# EUROPEAN PATENT APPLICATION

(11) **EP 3 300 107 A1**
(43) Date of publication of application: **28.03.2018**
(21) Application number: 17167243.9
(22) Date of filing: 20.04.2017
(51) Int. Cl.: H01L 25/075, H01L 33/60, F21S 8/10, F21V 7/00, F21Y 105/10, F21Y 115/10

(54) **LIGHT EMITTING DIODE ARRAY OPTICAL CUP STRUCTURE WITH A FOCAL POSITION**

(30) Priority: 22.09.2016 TW 105214530 U
(71) Applicant: Excellence Opto. Inc., Miaoli County 35053 (TW)
(72) Inventor: Wu, Chun-Der, 35053 Miaoli County, Hsinchu Science Park (TW); Tseng, Kuo-Shu, 35053 Miaoli County, Hsinchu Science Park (TW); Huang, Chang-Ching, 35053 Miaoli County, Hsinchu Science Park (TW); Kuo, Kun-Hua, Pomona, CA 91766 (US); Reniger, Bruce Lynn, SE Grand Rapids, MI 49512 (US)
(74) Representative: 2K Patentanwälte Blasberg Kewitz & Reichel

(57) **Abstract**

A light emitting diode (LED) array optical cup structure with a focal position includes a substrate (10), at least three reflective optical cups (20) disposed on the substrate (10), and a plurality of LEDs (30) in a quantity corresponding to the reflective optical cups (20). The reflective optical cups (20) are arranged closely side by side to form a geometric shape, and each is tapered downwards to form a cone-shaped accommodating space (21) having an opening (22). The LEDs (30) are disposed on the substrate (10) and respectively accommodated in the cone-shaped accommodating spaces (21), and form a focal position (40) at a center thereof. Accordingly, with the design of the reflective optical cups (20) arranged closely side by side, the LEDs (30) are caused to produce the focal position (40), and so existing conventional secondary optical components (50) may be adopted to save production costs and satisfy manufacturing requirements.

## Description

### FIELD OF THE INVENTION

The present invention relates to a light source of a lighting device, and particularly to a light emitting diode (LED) array optical cup structure with a focal position.

### BACKGROUND OF THE INVENTION

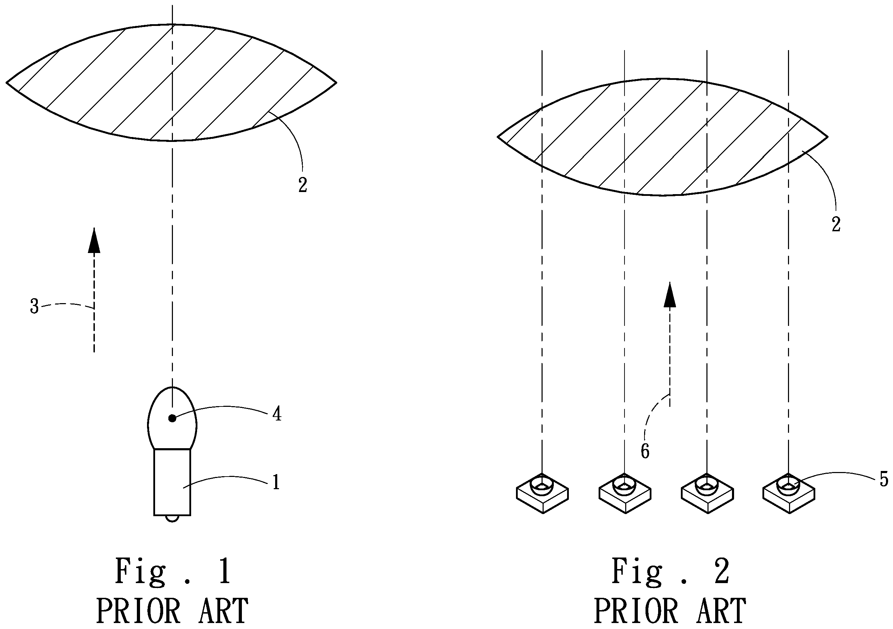

Fig. 1 shows a schematic diagram of an optical structure of a conventional light source applied in a vehicle light. The optical structure includes a conventional light source 1 and a focusing lens 2 (secondary optical component). A light direction 3 of the conventional light source 1 emits towards the focusing lens 2. To control the angle and range of light emission for an optimum focusing effect, an installation position of the conventional light source 1 needs to be at a focus 4 of the focusing lens 2, so as to allow the focusing lens 2 to position the focus 4. Such design efficiently controls the angle and range of light emission.

With the rise of light emitting diodes (LEDs), the conventional light source 1 is gradually replaced by LED light sources. For example, the Taiwan Patent Nos. 1321364, M512292 and 1428535 disclose associated patents. In a current LED light source, a single LED chip is usually packaged in a single reflecting optical cup, or multiple LED chips are packaged in a single reflective optical cup. That is to say, the LED structure is a single reflective optical cup, and so each LED structure is a single light source focus. Thus, multiple LED structures assembled form and present multiple light source focuses.

Further, the light intensity (brightness) of a single LED light source is lower and has a smaller illumination angle, and multiple LED light sources are thus collectively utilized to increase overall brightness and divergence angle. Referring to Fig. 2, when multiple LEDs 5 are directly applied to the focusing lens 2 in Fig. 1, light directions 6 of the LEDs 5 also emit toward the focusing lens 2. However, the above approach of utilizing multiple LEDs 5 produces multiple light source focuses, in a way that the LEDs 5 cannot achieve a focal position for the focusing lens 2 to perform positioning. As a result, the focusing lens 2 is incapable of controlling the emission angle and range and causes an issue of dispersed light. In other words, when applied to a vehicle light, such dispersed light in the above design of multiple LEDs affects the perception of users of opposite lanes and causes driving hazards.

That is to say, a conventional design of multiple LEDs 5 assembled causes mismatch in the focusing lens 2 (secondary optical component), which then needs to be re-designed in practice in order to coordinate with an LED assembly having multiple light source focuses. Further, the structure of the secondary optical component has an enlarged volume due to multiple dispersed light source focuses, and leads to not only space waste and environmental unfriendliness due to increased materials used, but also increased costs and reduced manufacturing efficiency.

### SUMMARY OF THE INVENTION

Therefore, it is a primary object of the present invention to provide a light emitting diode (LED) array optical cup structure with a focal position. The LED array optical cup structure is directly applicable to a conventional secondary optical component to satisfy application requirements.

The present invention provides an LED array optical cup structure with a focal position. The LED array optical cup structure includes a substrate, at least three reflective optical cups disposed on the substrate, and a plurality of LEDs in a quantity corresponding to the reflective optical cups. The reflective optical cups are arranged closely side by side to form a geometric shape, and each tapers downwards to form a cone-shaped accommodating space with an opening. The LEDs are disposed on the substrate and respectively accommodated in the cone-shaped accommodating spaces, and form a focal position at a center of the LEDs.

Accordingly, as opposed to the prior art, through the close and side by side arrangement of the reflective optical cups, the present invention allows the LEDs to produce a focal position. Thus, the present invention may adopt existing conventional secondary optical components without needing a new design, so that production costs are reduced and manufacturing needs are satisfied by adopting such conventional small-sized and low-cost secondary optical components.

### BRIEF DESCRIPTION OF THE DRAWINGS

Fig. 1 is a schematic diagram of an optical structure of a conventional light source;
Fig. 2 is a schematic diagram of an optical structure of a plurality of single-cup LED light sources;
Fig. 3 is a top view of a structure of multi-cup LED light sources according to an embodiment of the present invention;
Fig. 4 is a section view of a structure of multi-cup LED light sources according to an embodiment of the present invention;
Fig. 5 is a schematic diagram of a structure of multi-cup LED light sources according to an embodiment of the present invention;
Fig. 6 is a first top view of a structure of multi-cup LED light sources according to another embodiment of the present invention;
Fig. 7 is a second top view of a structure of multi-cup LED light sources according to another embodiment of the present invention;
Fig. 8 is a third top view of a structure of multi-cup LED light sources according to another embodiment of the present invention;
Fig. 9 is a first section view of a structure of multi-cup LED light sources according to another embodiment of the present invention;
Fig. 10 is a second section of a structure of multi-cup LED light sources according to another embodiment of the present invention; and
Fig. 11 is a third section view of a structure of multi-cup LED light sources according to another embodiment of the present invention.

### DETAILED DESCRIPTION OF THE PREFERRED EMBODIMENTS

To better understand the features, objects and effects of the present invention, details of the present invention are given in preferred embodiments with the accompanying drawings below.

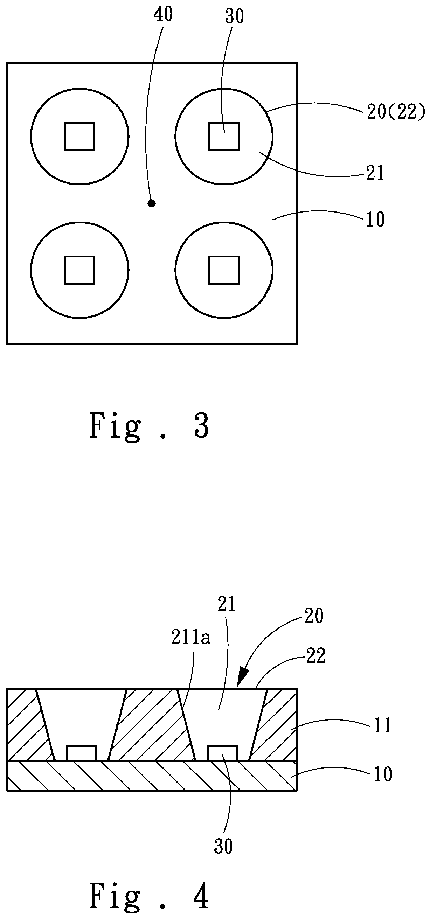

Referring to Fig. 3 and Fig. 4, the present invention provides a light emitting diode (LED) array optical cup structure with a focal position. The LED array optical cup structure includes a substrate 10, at least three reflective optical cups 20 disposed on the substrate 10, and a plurality of LEDs 30 in a quantity corresponding to the reflective optical cups 20. In practice, the substrate 10 may include a packaging material 11, which forms the reflective optical cups 20 while secures the LEDs 30 at the same time.

The reflective optical cups 30 are arranged closely side by side to form a geometric shape. In this embodiment, four reflective optical cups 20 are arranged closely to form a quadrilateral as an example. Each of the reflective optical cups 20 is tapered downwards to form a cone-shaped accommodating space 21 having an opening 22. The LEDs 30 are disposed on the substrate 10, and are respectively accommodated in the cone-shaped accommodating spaces 21. Further, the LEDs 30 form a focal position 40 at a center of the reflective optical cups 30.

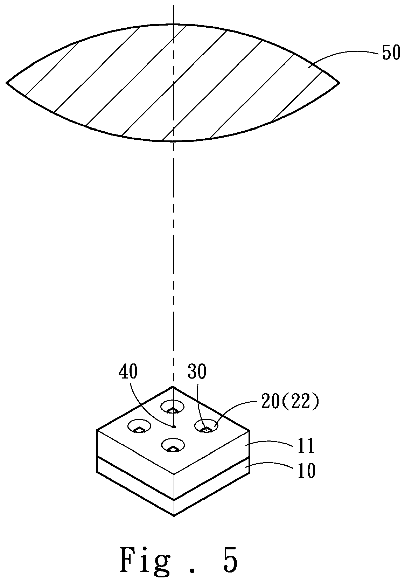

Referring to Fig. 5, using the focal position 40 in the present invention, existing conventional secondary optical components can be adopted in conjunction with a focusing lens 50 without needing to re-design the secondary optical components, hence satisfying manufacturing requirements.

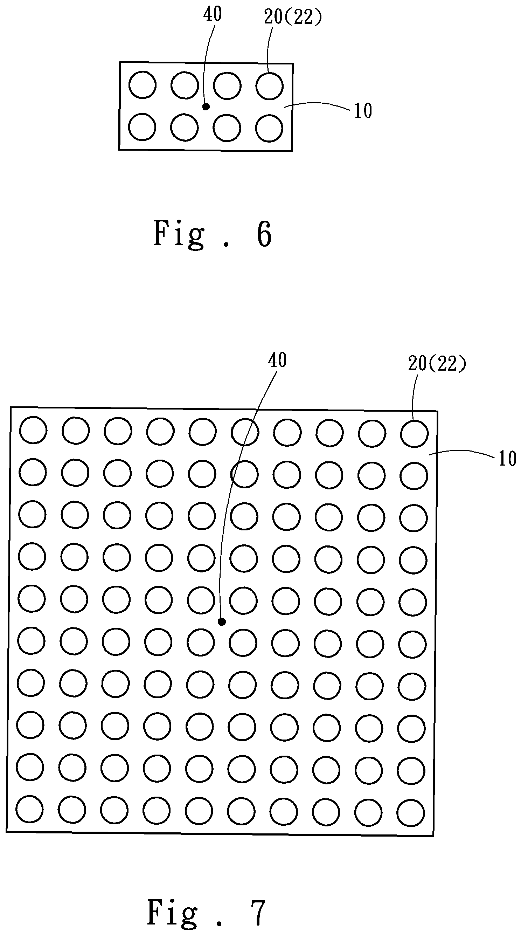

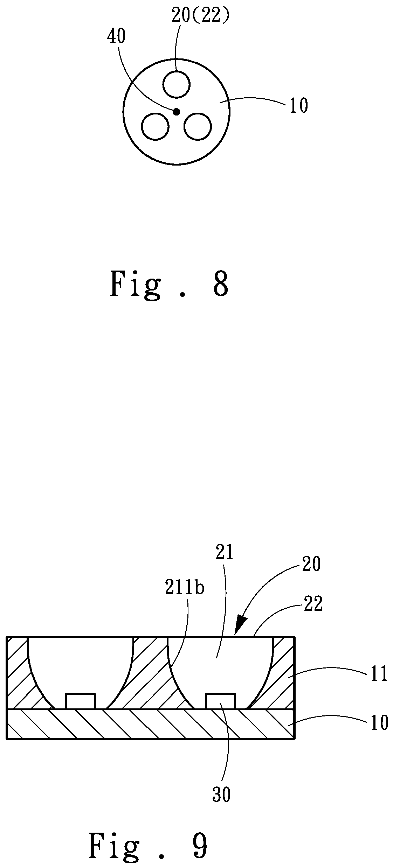

Referring to Fig. 6, Fig. 7 and Fig. 8, the geometric shape formed by the reflective optical cups 20 arranged closely side by side may be a polygon, with each side of the geometric shape provided with at least two of the reflective optical cups 20. Preferably, the reflective optical cups 20 are in an array, e.g., a 2*4 array as shown in Fig. 6, or a 10*10 array as shown in Fig. 7, or other kinds of polygons, e.g., a triangle, a pentagon or a hexagon, given that two of the reflective optical cups 20 are provided at each of the sides. Further, the reflective optical cups 20 may also be in a circular arrangement or a straight line arrangement, in which a least number of the reflective optical cups 20 being only three (as shown in Fig. 8).

Further, the opening 22 of each cone-shaped accommodating space 21 is not limited to any specific shape, and may be selected from a group consisting of a polygon, a circle or an ellipsoid, or other types of patterns, depending on the overall optical design of a product to be applied to. Further, the shapes of the openings 22 of the reflective optical cups 22 need not be the same, and may be different.

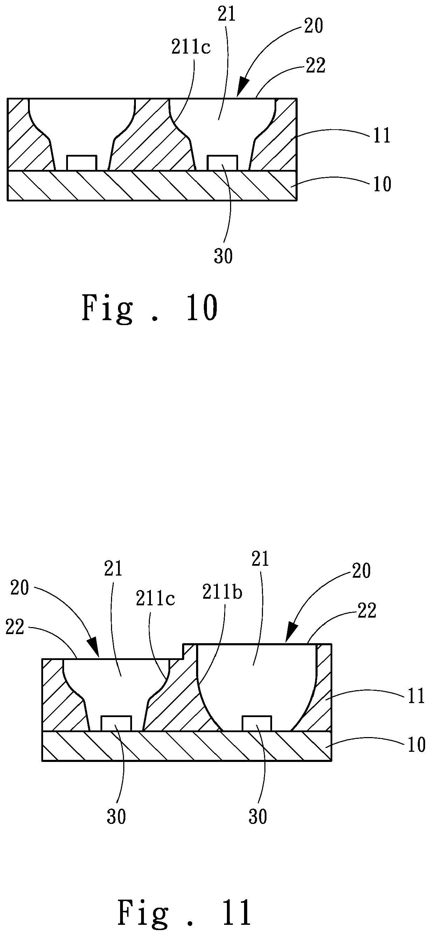

Referring to Fig. 9, Fig. 10 and Fig. 11, cross section segments 211a, 211b and 211c of the cone-shaped accommodating spaces 21 may be at least one selected from a group consisting of a straight line and an arc. The segment 211 a is a straight line as shown in Fig. 4, the segment 211b is an arc as shown in Fig. 9, and the segment 211 c is a combination of a straight line and an arc as shown in Fig. 10. Further, a cross section of the cone-shaped accommodating space 21 of each of the reflective optical cups 20 may include different segments 211b and 211c, as shown in Fig. 11. Further, LEDs in different specifications may be used in the reflective optical cups of the present invention, e.g., LEDs in different colors are arranged for a combination. A manufacturer may use different combinations based on actual needs to satisfy application requirements.

In conclusion, the present invention provides following features as opposed to the prior art.
1. With the design of closely arranging the reflective optical cups side by side, the LEDs are caused to produce a focal position. Thus, the present invention may adopt existing conventional secondary optical components without needing a new design.
2. The present invention provides a design of a focal position, and so the secondary optical components involved may be miniaturized to reduce production costs and satisfy manufacturing requirements.
3. The number of reflective optical cups may be appropriately selected to meet different brightness requirements.
4. LEDs in different specifications, i.e., LEDs in different colors, may be selected and placed in the reflective optical cups to satisfy requirements of matching different specifications.

## Claims

1. A light emitting diode (LED) array optical cup structure with a focal position, comprising:
a substrate (10);
at least three reflective optical cups (20), disposed on the substrate (10), arranged closely side by side to form a geometric shape, each of the reflective optical cups (20) tapered downwards and forming a cone-shaped accommodating space (21) having an opening (22); and
a plurality of LEDs (30), in a quantity corresponding to the reflective optical cups (20), disposed on the substrate (10) and respectively accommodated in the cone-shaped accommodating spaces (21), forming a focal position (40) at a center thereof.

2. The LED array optical cup structure with a focal position of claim 1, wherein the geometric shape is a polygon.

3. The LED array optical cup structure with a focal position of claim 2, wherein each side of the geometric shape is provided with at least two of the reflective optical cups (20).

4. The LED array optical cup structure with a focal position of any of the claims 1 - 3, wherein the reflective optical cups (20) are arranged in an array.

5. The LED array optical cup structure with a focal position of any claims 1-4, wherein the reflective optical cups (20) are arranged in circle.

6. The LED array optical cup structure with a focal position of any of the claims 1 to 5, wherein a shape of each of the openings (22) is selected from a group consisting of a polygon, a circle and an ellipsoid.

7. The LED array optical cup structure with a focal position of any of the claims 1 to 6, wherein shapes of the openings (22) of the reflective optical cups (20) are different.

8. The LED array optical cup structure with a focal position of any of the claims 1 to 7, wherein a cross section of each of the cone-shaped accommodating spaces (21) comprises a segment that is at least one selected from a group consisting of a straight line and an arc.

9. The LED array optical cup structure with a focal position of any of the claims 1 to 8, wherein the cross section of each of the cone-shaped accommodating spaces (21) comprises differently-shaped segments.

10. The LED array optical cup structure with a focal position of any of the claims 1 to 9, wherein the substrate (10) comprises a packaging material (11) that forms the reflective optical cups (20).

11. The LED array optical cup structure with a focal position of any of the claims 1 to 10, wherein the LEDs (30) in the reflective optical cups (20) are in different specifications.

12. The LED array optical cup structure with a focal position of claim 11, wherein the LEDs (30) in the reflective optical cups (20) are in different colors.
